# EUROPÄISCHE PATENTSCHRIFT

(11) **EP 3 020 066 B1**
(45) Veröffentlichungstag und Bekanntmachung des Hinweises auf die Patenterteilung: **05.01.2022**
(21) Anmeldenummer: 14744291.7
(22) Anmeldetag: 10.07.2014
(51) Int. Cl.: H01L 21/67

(54) **VORRICHTUNG ZUM ENTFERNEN EINES RINGFÖRMIGEN VERSTÄRKUNGSRANDS VON EINEM GESCHLIFFENEN HALBLEITERWAFER**
DEVICE FOR REMOVING A RING-SHAPED REINFORCEMENT EDGE FROM A GROUND SEMICONDUCTOR WAFER
DISPOSITIF D'ÉLIMINATION D'UNE COLLERETTE ANNULAIRE SUR UNE TRANCHE SEMI-CONDUCTRICE RECTIFIÉE

(30) Priorität: 10.07.2013 EP 13175880
(43) Veröffentlichungstag der Anmeldung: 18.05.2016
(73) Patentinhaber: mechatronic Systemtechnik GmbH, 9500 Villach (AT)
(72) Erfinder: SCHOBER, Walter, A-9232 St. Martin/Rosegg (AT)
(74) Vertreter: Jell, Friedrich
(86) Internationale Anmeldenummer: PCT/EP2014/064877
(87) Internationale Veröffentlichungsnummer: WO 2015/004262

(56) Entgegenhaltungen:
- DE-A1-102010 039 798
- JP-A- 2007 059 829
- US-A- 4 403 567
- US-A1- 2007 077 731
- US-A1- 2009 165 277
- US-A1- 2010 055 877

## Beschreibung

### Technisches Gebiet

Die Erfindung betrifft eine Vorrichtung zum Entfernen eines ringförmigen Verstärkungsrands von einem geschliffenen Halbleiterwafer, der mit einer elastischen Trägerfolie stoffschlüssig verbunden und über diese Trägerfolie an einem umlaufenden Waferrahmen befestigt ist, mit einer Halteeinrichtung, die eine Auflage mit Ansaugöffnungen zum Halten des Halbleiterwafers aufweist, und mit einer Trenneinrichtung, die Mittel zum einstückigen Lösen des Verstärkungsrands vom Halbleiterwafer und von der Trägerfolie umfasst.

### Stand der Technik

Um einen durch ein Schleif- und Trennverfahren auf der Rückseite eines Halbleiterwafers zurückgebliebenen Verstärkungsrand entfernen zu können, ist es aus dem Stand der Technik bekannt (DE102010007769A1), auf eine Trägerfolie, auf die der Halbleiterwafer auflaminiert ist, einen Impuls auszuüben. Damit soll die Klebeverbindung zwischen Verstärkungsrand und Trägerfolie geschwächt werden, was in weiterer Folge ein einstückiges Abziehen des Verstärkungsrands von der Trägerfolie erlaubt. Nachteilig führen jedoch solche Stoßbelastungen auch zu Erschütterungen im Bereich der aktiven Waferfläche, die bekanntermaßen unmittelbar an den Verstärkungsrand anschließt. Die Gefahr einer Beschädigung der aktiven Waferfläche mit ihren Halbleiterstrukturen ist somit vergleichsweise hoch. Dies gilt insbesondere dann, wenn es sich um einen Halbleiterwafer handelt, der mithilfe eines Schleifverfahrens in seiner Dicke reduziert wird und so eine Waferdicke kleiner 150 µm erreichen zu können.

Nach der US20100055877A1 wird ein Verfahren zum Lösen eines ringförmigen Verstärkungsrands geoffenbart, bei dem die Trägerfolie des Waferrahmens von unten mit UV-Licht bestrahlt wird, um Haftkräfte zu verringern bzw. die stoffschlüssige Verbindung zu erweichen. Nachteilig können damit auch umliegende Bereiche und somit auch Bereiche an der aktiven Waferfläche des Halbleiterwafers erweicht werden, wodurch beim Abheben des Verstärkungsrands mit einem unerwünschten Mitlösen von aktiver Waferfläche zu rechnen ist. Dies muss umso mehr befürchtet werden, da beim Abheben des Verstärkungsrands mit einem Zurückschnellen der zwischen Verstärkungsrand und Halbleiterwafer gestreckten Folie zu rechnen ist, die in diesem Bereich frei gestellt ist (vgl. US20100055877A1: Fig. 15B).

### Darstellung der Erfindung

Die Erfindung hat sich daher die Aufgabe gestellt, eine Vorrichtung zum Entfernen eines Verstärkungsrands der eingangs geschilderten Art derart konstruktiv zu verändern, dass damit beschädigungsfrei ein Verstärkungsrand von der aktiven Waferfläche eines geschliffenen Halbleiterwafers entfernt werden kann. Zudem soll die Vorrichtung konstruktiv einfach ausgestaltet sein.

Die Erfindung löst die gestellte Aufgabe dadurch, dass die Haltereinrichtung eine die Auflage umfassende Spanneinrichtung zum Einspannen des Waferrahmens und/oder der Trägerfolie aufweist, wobei die Spanneinrichtung mit der Auflage zur Erzeugung einer Streckung der Trägerfolie zwischen Spanneinrichtung und Verstärkungsrand zusammenwirkt, und dass die Trenneinrichtung eine Werkzeugführung mit einem Zerteilwerkzeug zum Bewegen des Zerteilwerkzeugs zwischen gestrecker Trägerfolie und Verstärkungsrand aufweist, um den Verstärkungsrand in einem Stück von der durch ein Zusammenwirken von Spanneinrichtung und Auflage gestreckten Trägerfolie zu lösen.

Weist die Haltereinrichtung eine die Auflage umfassende Spanneinrichtung zum Einspannen des Waferrahmens und/oder der Trägerfolie auf, wobei die Spanneinrichtung mit der Auflage zur Streckung der Trägerfolie zusammenwirkt, kann die Trägerfolie auf ein Ablösen des Verstärkungsrands besonders vorteilhaft vorbereitet werden. Die durch ein Zusammenwirken von Spanneinrichtung und Auflage gestreckten Trägerfolie sorgt nämlich für eine Scherbelastung in der Klebeverbindung zwischen Trägerfolie und Verstärkungsrand, wodurch die Klebeverbindung geschwächt werden kann. Diese Schwächung der Klebeverbindung erfolgt jedoch im Gegensatz zum Stand der Technik erschütterungsfrei, was vorteilhaft Beschädigungen der Halbleiterstrukturen auf der aktiven Waferfläche des Halbleiterwafers vermeiden kann. Besonders kann sich die Erfindung jedoch dadurch auszeichnen, dass sich aufgrund der gestreckten elastischen Trägerfolie erhöhte Randspannungsspitzen ausbilden. Diese Randspannungsspitzen sind zudem aufgrund der die Auflage umfassenden Spanneinrichtung gleichmäßig um den Verstärkungsrand verteilt. Damit können vorteilhafte Voraussetzungen zum mechanischen Lösen bzw. Abheben des Verstärkungsrands geschaffen werden, wenn die Trenneinrichtung eine Werkzeugführung mit einem Zerteilwerkzeug zum Bewegen des Zerteilwerkzeugs zwischen Trägerfolie und Verstärkungsrand aufweist. Das Zerteilwerkzeug kann somit in einem Bereich am Verstärkungsrand angesetzt werden, wo die stoffschlüssige Verbindung erheblich geschwächt ist, was nicht nur ein Einschieben des Zerteilwerkzeugs zwischen Trägerfolie und Verstärkungsrand erleichtert, sondern auch einen Bruch des Verstärkungsrands vermeidet. Erfindungsgemäß kann damit ein Entfernen des Verstärkungsrands in einem Stück sichergestellt werden. Zudem kann die durch ein Zusammenwirken von Spanneinrichtung und Auflage gestreckten Trägerfolie für ein schwingungsarmes Entfernen des Verstärkungsrands sorgen, was Beschädigungen der Halbleiterstrukturen des Halbleiterwafers vermeiden kann. Außerdem kann durch die Verwendung eines spanfreien Zerteilwerkzeugs der konstruktive Aufwand an der Vorrichtung gering gehalten werden.

Im Allgemeinen wird erwähnt, dass die Spanneinrichtung mit der Auflage zur Streckung der Trägerfolie beispielsweise über ein Ziehen an der Trägerfolie zusammenwirken kann. Diese Zugbelastung kann beispielsweise durch ein Ansaugen der Trägerfolie und/oder des Waferrahmens an die Spanneinrichtung oder auch durch mechanische Führungen in die elastische Trägerfolie eingeleitet werden, mit weleher Führung ein Teil der Trägerfolie und/oder der Waferrahmen in seiner/ihrer Lage gegenüber der Auflage versetzt wird/werden.

Die Konstruktionsverhältnisse an der Vorrichtung können vereinfacht werden, wenn die Halteeinrichtung eine zwischen Spanneinrichtung und Auflage vorgesehene Führung aufweist. Damit kann nämlich eine von der Spanneinrichtung gehaltene Trägerfolie und/oder ein gehaltener Waferrahmen von einer Ausgangslage in eine Spannlage übergeführt werden, was zur Streckung der Trägerfolie zwischen Spanneinrichtung und Verstärkungsrand genutzt werden kann. Zudem kann damit die stoffschlüssige Verbindung zwischen Trägerfolie und Spanneinrichtung sicher geschwächt werden, was zur Erhöhung der Standfestigkeit der Vorrichtung genutzt werden kann. Konstruktiv einfach gelöst kann die Führung als Linearführung ausgeführt sein - hierbei kann sich eine Schwalbenschwanzführung mit ihrer erhöhten Seitenstabilität entlang der Führungsbahn auszeichnen.

Neben der Streckung der Trägerfolie kann auch noch eine Schwächung der stoffschlüssigen Verbindung erreicht werden, wenn die Führungsbahn gegenüber der Auflagefläche der Auflage geneigt verläuft, um die stoffschlüssige Verbindung zwischen Trägerfolie und Verstärkungsrand auf Schälung zu beanspruchen. Die Trägerfolie kann vom Verstärkungsrand damit richtiggehend abgezogen werden, wobei eine gleichmäßige Belastung auf den Verstärkungsrand bzw. auf die Trägerfolie sicherstellbar ist - welche gleichmäßige Belastung sich bei diesem Verfahrensschritt aufgrund der um die Auflage gestreckten Trägerfolie einstellt. Beschädigungen auf der aktiven Waferfläche des Halbleiterwafers können dadurch vermieden werden. Vorzugsweise kann eine gegenüber der Auflage senkrecht verlaufende Führungsbahn den konstruktiven Aufwand an der Vorrichtung weiter reduzieren.

Die Anforderungen an die Spanneinrichtung zum Greifen der Trägerfolie oder des Waferrahmens können sich reduzieren, wenn die Führung die Spanneinrichtung von einer mit der Auflagefläche planen Ausgangslage in eine gegenüber der Auflagefläche zurückversetzten Spannlage beweglich lagert. Zudem kann eine zurückversetzte Spannlage für vereinfachte Führungsverhältnisse beim Zerteilwerkzeug sorgen, indem die vom Verstärkungsrand zurückspringende Trägerfolie eine Bewegungsfreiheit für das Zerteilwerkzeug ermöglichen kann.

Die Trägerfolie und/oder der Waferrahmen können standfest und konstruktiv einfach mit der Spanneinrichtung über ihre Ansaugöffnungen fest verbunden werden.

Ist zwischen Halteeinrichtung und Zerteilwerkzeug ein Drehlager vorgesehen, kann sich im Bereich des Zerteilwerkzeugs eine konstruktive Vereinfachung dahin gehend ergeben, dass über eine Drehung des gehaltenen Halbleiterwafers samt Trägerfolie und Waferrahmen ein vergleichsweise schmales Zerteilwerkzeug für ein Abheben des Verstärkungsrands ausreichen kann.

Vereinfachte Konstruktionsverhältnisse können sich ergeben, wenn die Drehachse des Drehlagers zur Führungsachse der Werkzeugführung geneigt, insbesondere senkrecht, verläuft. Zudem kann mit einer derartigen Werkzeugführung eine besonders vorteilhafte Trennwirkung zwischen Verstärkungsrand und Trägerfolie ermöglichen, indem vom Zerteilwerkzeug die Trägerfolie im Wesentlichen vom Verstärkungsrand abgezogen wird. Die mechanischen Belastungen auf den Verstärkungsrand können damit gering gehalten werden, was dem einstückigen Entfernen des Verstärkungsrands dienlich sein kann.

Vorzugsweise kann das Zerteilwerkzeug eine Keilschneide aufweisen, insbesondere als Messer oder Spalter ausgeführt sein, um damit die konstruktiven Voraussetzungen der Vorrichtung zu vermindern.

Die stoffschlüssige Verbindung zwischen Trägerfolie und Verstärkungsrand kann weiter geschwächt werden, indem die Trenneinrichtung eine auf den Verstärkungsrand gerichtete Strahlungsquelle aufweist, die die stoffschlüssige Verbindung zwischen Trägerfolie und Verstärkungsrand aufweicht. UV Bestrahlungsquellen können sich hier insbesondere auszeichnen.

Die Halbleiterstrukturen können auf konstruktiv einfache Weise geschützt werden, indem der Strahlungsquelle eine Blende nachgeordnet ist, um die Abstrahlung der Strahlungsquelle auf den Verstärkungsrand zu beschränken.

Vorteilhaft kann die Auflage den Halbleiterwafer an der Trägerfolie ansaugen, um damit ein Lösen des Verstärkungsrands von der Trägerfolie zu erleichtern.

Sind die Ansaugöffnungen der Auflage der Innenseite des Verstärkungsrands umlaufend angeordnet, kann das Lösen des Verstärkungsrands beim Trennvorgang erleichtert werden. Die umlaufenden Ansaugöffnungen können nämlich eine Art Befestigungskante ausbilden, von der der zu lösende Verstärkungsrand abgehebelt werden kann.

### Kurze Beschreibung der Zeichnung

In den Figuren ist beispielsweise der Erfindungsgegenstand anhand eines Ausführungsbeispiels näher dargestellt. Es zeigen
- Fig. 1: eine teilweise aufgerissene Seitenansicht auf die Vorrichtung mit Halbleiterwafer, elastische Trägerfolie und Waferrahmen,
- Fig. 2: eine Detailansicht der Fig. 1,
- Fig. 3: eine in der Lage der Spanneinrichtung 10 veränderte Detailansicht der Fig. 1 und
- Fig. 4: eine Draufsicht auf die Vorrichtung ohne Halbleiterwafer, elastische Trägerfolie und Waferrahmen.

### Weg zur Ausführung der Erfindung

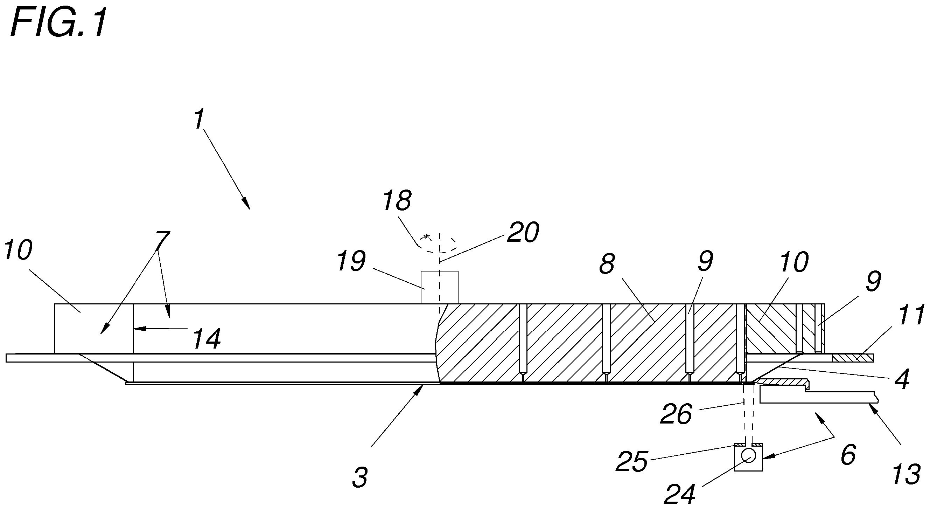

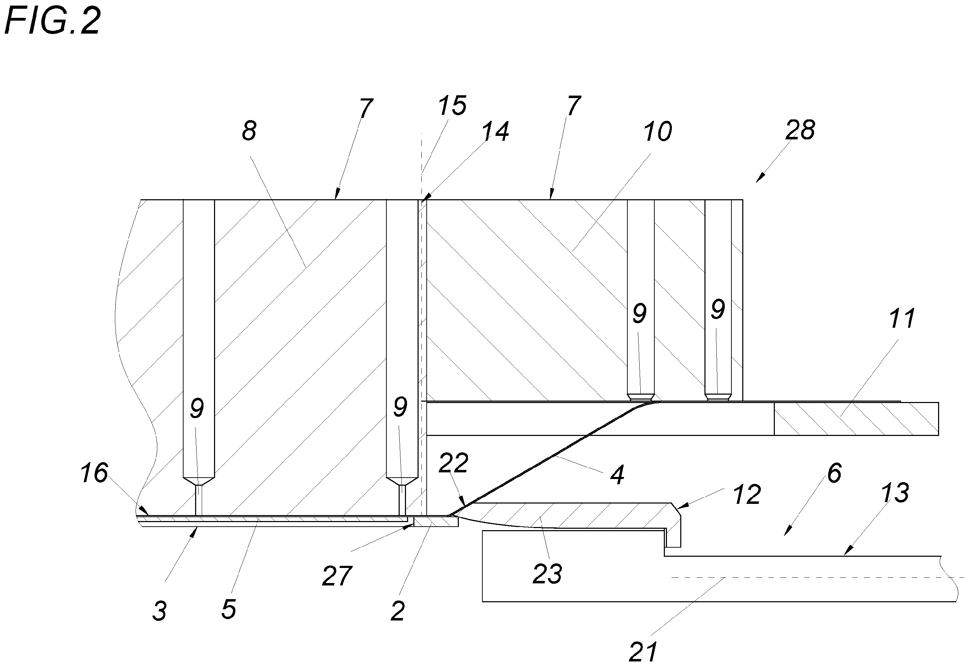

In der beispielsweise nach Fig. 1 dargestellten Vorrichtung 1 zum Entfernen eines ringförmigen Verstärkungsrands 2 von einem geschliffenen Halbleiterwafer 3 kann die elastische Trägerfolie 4 erkannt werden, auf die der Halbleiterwafer 3 auflaminiert bzw. mit der der Halbleiterwafer 3 stoffschlüssig verbunden ist. Wie in Fig. 2 besser zu erkennen, ist der Verstärkungsrand 2 bereits von der aktiven Waferfläche 5 des Halbleiterwafers 3 getrennt. Solch ein Trennverfahren kann beispielsweise durch einen Laserschnitt erfolgen. Der Verstärkungsrand 2 bildet sich im Wesentlichen durch einen Schleifvorgang auf der Rückseite des Halbleiterwafers 3 um seine aktive Waferfläche 5 auszudünnen, die mit einer nicht näher dargestellten Halbleiterstruktur versehen ist. Der zu Stabilitätszecken beim Schleifvorgang zurückbleibende Verstärkungsrand 2 muss nun von der Trägerfolie 4 entfernt werden, um den Halbleiterwafer 3 weiter bearbeiten zu können. Dieses Entfernen muss jedoch derart vonstattengehen, dass dabei die aktive Waferfläche 5 nicht beschädigt wird, wenn eine Trenneinrichtung 6 mit ihren Mitteln den Verstärkungsrand 2 einstückig von der Trägerfolie 4 ablöst bzw. abhebt. Erschwerend kommt hinzu, dass in diesem Verfahrensschritt der Halbleiterwafer 3 von einer Halteeinrichtung 7 auf einer Auflage 8 mit Hilfe von Ansaugöffnungen 9 festgehalten wird und damit empfindlich auf Schwingungen der Trägerfolie 4 reagiert.

Um ein hohes Maß an Beschädigungsfreiheit zu erreichen, schlägt die Erfindung vor, der Haltereinrichtung 7 mit einer Spanneinrichtung 10 zu versehen, die die Auflage 8 umfasst und die Trägerfolie 4 einspannt, und zwar derart, dass es zu einer Streckung der Trägerfolie 4 kommt. Dies wird durch ein Anziehen an der Trägerfolie 2 erreicht, indem die Spanneinrichtung 10 ebenso mit Ansaugöffnungen 9 versehen ist, die die Folie an die Spanneinrichtung 10 anziehen. Vorstellbar, jedoch nicht näher dargestellt, ist, dass die Spanneinrichtung 10 ihre Spannkräfte alternativ oder auch zusätzlich auf den Waferrahmen 11 einleitet, an den die Trägerfolie 4 befestigt ist, um diese damit zu strecken. Die stoffschlüssige Verbindung zwischen Verstärkungsrand 2 und Trägerfolie 4 ist damit erheblich geschwächt - dies zudem unter Berücksichtigung der elastischen Eigenschaft der Trägerfolie 4 und den dadurch in der Klebeverbindung entstehenden Randspannungsspitzen. Die Trenneinrichtung 6 kann daher zwischen Trägerfolie 4 und Verstärkungsrand 2 ein geführtes Zerteilwerkzeug 12 erschütterungsfrei einbringen, um damit den Verstärkungsrand 2 in einem Stück von der Trägerfolie 3 zu lösen. Von dieser nach Fig. 2 teilweise dargestellten Werkzeugführung 13 ist ihr Werkzeughalter erkennbar. Der Verstärkungsrand 2 kann damit vom Halbleiterwafer gefahrlos entfernt werden, wobei sich zudem durch die Verwendung eines Zerteilwerkzeugs 12 eine konstruktiv einfache Vorrichtung 1 ergibt.

Im Allgemeinen wird erwähnt, dass ein Waferrahmen 11 mit aufgespannter Trägerfolie oftmals als "Film-Frame" bezeichnet wird, der als Träger für den Halbleiterwafer 3 dient.

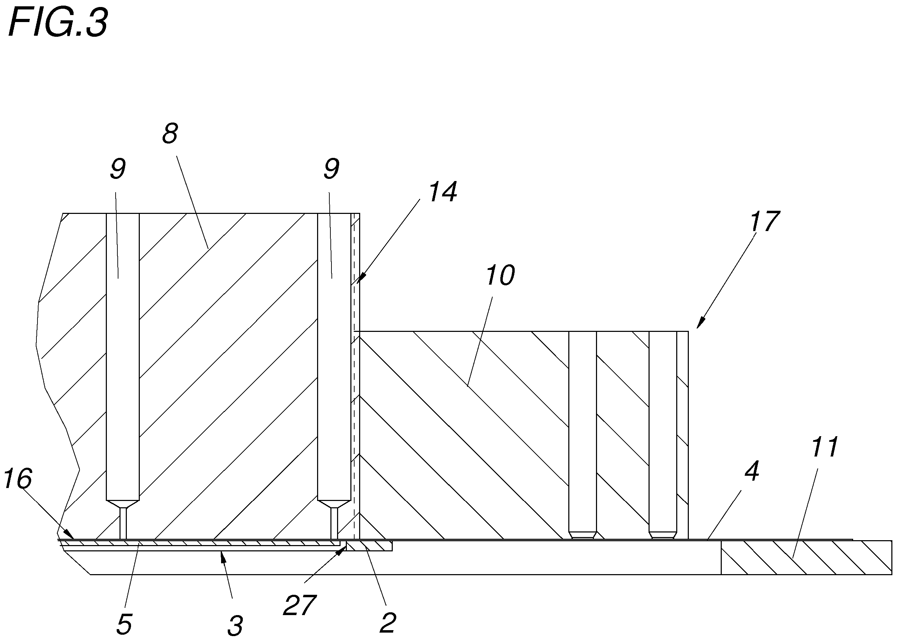

Die Streckung der Trägerfolie 4 wird unter Verwendung einer Führung 14 zwischen Spanneinrichtung 10 und Auflage 8 erreicht, welche Führung 14 als lineare Gleitführung ausgeführt ist. Die Führungsbahn 15 der Führung 14 verläuft senkrecht gegenüber der Auflagefläche 16 der Auflage 8, wodurch die Spanneinrichtung 10 in eine gegenüber der Auflagefläche 16 zurückversetzte Spannlage 28 bewegt werden kann, wie diese im Detail der Fig. 2 zu entnehmen ist. In dieser Spannlage 28 wird die Trägerfolie 4 mindestens zwischen Spanneinrichtung 10 und Verstärkungsrand 2 gedehnt bzw. gestreckt, um die vertikale Verschiebung der Spanneinrichtung 10 aufnehmen zu können, die sich ausgehend von einer mit der Auflagefläche 16 planen Ausgangslage 17 ergibt. Diese Ausgangslage 17 der Spanneinrichtung 10 ist nach Fig. 3 näher dargestellt.

Der Verstärkungsrand 2 kann von der Trägerfolie gleichmäßig abgelöst werden, indem der Verstärkungsrand 2 in eine Drehbewegung 18 gegenüber dem Zerteilwerkzeug 12 versetzt wird. Zu diesem Zweck ist zwischen Halteeinrichtung 7 und Zerteilwerkzeug 12 bzw. ihrer Werkzeugführung 13 ein Drehlager 19 vorgesehen. Die Drehachse 20 des Drehlagers 19 verläuft senkrecht zur Führungsachse 21 der Werkzeugführung 13, wodurch die Keilschneide des Zerteilwerkzeugs 12 in der Art eines Hebewerkzeugs den Verstärkungsrand 2 von der Trägerfolie 4 abhebt. Das Zerteilwerkzeug 12 ist hierfür in der Art eines Messers 23 ausgeführt.

Wie in Fig. 1 angedeutet, ist der Trenneinrichtung 7 auch eine Ultraviolettstrahlung abgebende Strahlungsquelle 24 (UV-Strahlungsquelle) zugeordnet. Diese Strahlungsquelle 24 ist auf den Verstärkungsrand 2 gerichtet und führt so zu einem Erweichen der stoffschlüssigen Verbindung zwischen Trägerfolie 4 und Verstärkungsrand 2. Das mechanische Ablösen des Verstärkungsrands 2 von der Trägerfolie 4 kann damit erheblich erleichtert werden.

Zum Schutz der Halbleiterstrukturen der aktiven Waferfläche 5 des Halbleiterwafers 3 ist der Strahlungsquelle 24 eine Blende 25 nachgeordnet, die die Abstrahlung 26 der Strahlungsquelle 24 auf den Verstärkungsrand 2 des Halbleiterwafers 3 beschränkt.

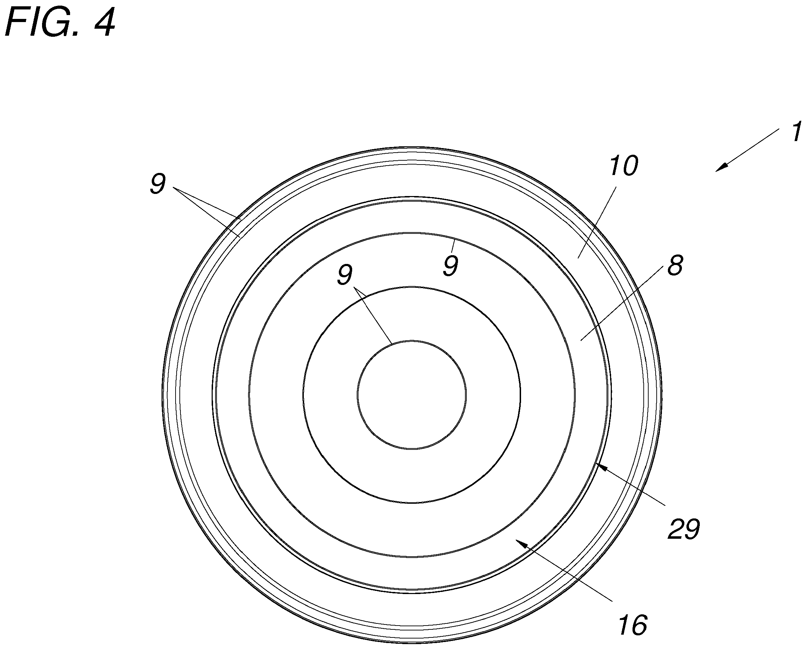

Der Halbleiterwafer 3 wird über die Trägerfolie 4 an die Auflage 8 angesaugt. Auf diese Weise werden Beschädigungen, verursacht durch die Haltereinrichtung 7, vermieden. Zudem umlaufen die Ansaugöffnungen 9 der Auflage 8 die Innenseite 27 des Verstärkungsrands 2, und bilden so eine geschlossene Kontur aus. Diese Kontur sorgt nicht nur für einen Schutz der aktiven Waferfläche 5, sondern dient auch als Befestigungskante 29 bzw. Abhebekante, um das Lösen des Verstärkungsrands 2 zu erleichtern, wie diese Kante nach Fig. 4 erkannt werden kann.

Im Allgemeinen wird erwähnt, dass die Ansaugöffnungen 9 durch über die Auflage 8 verteilte Öffnungen und/oder kreisringförmig ausgebildet sein können.

In der nach Fig. 4 ohne Halbleiterwafer, elastische Trägerfolie und Waferrahmen dargestellten Vorrichtung 1 ist zudem die Auflagefläche 16 der Auflage 8 zu erkennen. An diese Auflagefläche 16 schließt die Spanneinrichtung 10 mit ihren nach außen versetzten Ansaugöffnungen 9 an. Die Ansaugöffnungen 9 der Auflage 8 und der Spanneinrichtung 10 sind kreisringförmig ausgebildet.

## Patentansprüche

1. Vorrichtung zum Entfernen eines ringförmigen Verstärkungsrands (2) von einem geschliffenen Halbleiterwafer (3), der mit einer elastischen Trägerfolie (4) stoffschlüssig verbunden und über diese Trägerfolie (4) an einem umlaufenden Waferrahmen (11) befestigt ist, mit einer Halteeinrichtung (7), die eine Auflage (8) mit Ansaugöffnungen (9) zum Halten des Halbleiterwafers (3) an der Auflagefläche (16) der Auflage (8) aufweist, und mit einer Trenneinrichtung (6), die Mittel zum einstückigen Lösen des Verstärkungsrands (2) von der Trägerfolie (4) umfasst, wobei die Haltereinrichtung (7) eine die Auflage (8) umfassende Spanneinrichtung (10) zum Einspannen des Waferrahmens (11) und/oder der Trägerfolie (4) aufweist, **dadurch gekennzeichnet, dass** die Spanneinrichtung (10) mit der Auflage (8) zur Streckung der Trägerfolie (4) zwischen Spanneinrichtung (10) und Verstärkungsrand (2) zusammenwirkt, und dass die Trenneinrichtung (6) eine Werkzeugführung (13) mit einem Zerteilwerkzeug (12) zum Bewegen des Zerteilwerkzeugs (12) zwischen gestreckter Trägerfolie (4) und Verstärkungsrand (2) aufweist, um den Verstärkungsrand (2) in einem Stück von der durch ein Zusammenwirken von Spanneinrichtung (10) und Auflage (8) gestreckten Trägerfolie (4) zu lösen.

2. Vorrichtung nach Anspruch 1, **dadurch gekennzeichnet, dass** die Halteeinrichtung (7) zur Streckung der Trägerfolie (4) eine zwischen Spanneinrichtung (10) und Auflage (8) vorgesehen Führung (14), insbesondere Linearführung, aufweist.

3. Vorrichtung nach Anspruch 2, **dadurch gekennzeichnet, dass** die Führungsbahn (15) gegenüber der Auflagefläche (16) der Auflage (8) geneigt, insbesondere senkrecht, verläuft, um die stoffschlüssige Verbindung zwischen Trägerfolie (4) und Verstärkungsrand (2) auf Schälung zu beanspruchen.

4. Vorrichtung nach Anspruch 2 oder 3, **dadurch gekennzeichnet, dass** die Führung (14) die Spanneinrichtung (10) von einer mit der Auflagefläche (16) planen Ausgangslage (17) in eine gegenüber der Auflagefläche (16) zurückversetzte Spannlage (28) beweglich lagert.

5. Vorrichtung nach einem der Ansprüche 1 bis 4, **dadurch gekennzeichnet, dass** die Spanneinrichtung (10) Ansaugöffnungen (9) zum Ansaugen der Trägerfolie (4) und/oder des Waferrahmens (11) aufweist.

6. Vorrichtung nach einem der Ansprüche 1 bis 5, **dadurch gekennzeichnet, dass** zwischen Halteeinrichtung (7) und Zerteilwerkzeug (12) ein Drehlager (19) vorgesehen ist.

7. Vorrichtung nach Anspruch 6, **dadurch gekennzeichnet, dass** die Drehachse (20) des Drehlagers (19) zur Führungsachse (21) der Werkzeugführung (13) geneigt, insbesondere senkrecht, verläuft.

8. Vorrichtung nach einem der Ansprüche 1 bis 7, **dadurch gekennzeichnet, dass** das Zerteilwerkzeug (12) eine Keilschneide (22) aufweist, insbesondere als Messer (23) oder Spalter ausgeführt ist.

9. Vorrichtung nach einem der Ansprüche 1 bis 8, **dadurch gekennzeichnet, dass** die Trenneinrichtung (6) eine auf den Verstärkungsrand (2) gerichtete Strahlungsquelle (24) zum Erweichen der stoffschlüssigen Verbindung zwischen Trägerfolie (4) und Verstärkungsrand (2) aufweist.

10. Vorrichtung nach Anspruch 9, **dadurch gekennzeichnet, dass** der Strahlungsquelle (24) eine Blende (25) zur Beschränkung der Abstrahlung (26) der Strahlungsquelle (24) auf den Verstärkungsrand (2) nachgeordnet ist.

11. Vorrichtung nach einem der Ansprüche 1 bis 10, **dadurch gekennzeichnet, dass** die Auflage (8) den Halbleiterwafer (3) an der Trägerfolie (4) ansaugt.

12. Vorrichtung nach einem der Ansprüche 1 bis 11, **dadurch gekennzeichnet, dass** die Ansaugöffnungen (9) der Auflage (8) der Innenseite (27) des Verstärkungsrands (2) umlaufend angeordnet sind.

## Claims

1. Apparatus for removal of a ring-shaped reinforcement edge (2) from a ground semiconductor wafer (3), which wafer is connected with an elastic film (4) with material fit, and attached to a circumferential wafer frame (11) by way of this carrier film (4), the apparatus having a holding device (7) that has a support (8) having suction openings (9) for holding the semiconductor wafer (3) against the support surface (16) of the support (8), and having a severing device (6) that comprises means for detachment of the reinforcement edge (2) from the carrier film (4) in one piece, wherin the holding device (7) has a clamping device (10) that surrounds the support (8), for clamping the wafer frame (11) and/or the carrier film (4) in place, **characterized in that** the clamping device (10) interacts with the support (8) to produce stretching of the carrier film (4) between clamping device (10) and reinforcement edge (2), and that the severing device (6) has a tool guide (13) having a disaggregating tool (12), for moving the disaggregating tool (12) between stretched carrier film (4) and reinforcement edge (2), in order to detach the reinforcement edge (2) from the carrier film (4), which is stretched by an interaction of clamping device (10) and support (8), in one piece.

2. Apparatus according to claim 1, **characterized in that** the holding device (7) has a guide (14) provided between clamping device (10) and support (8), more particularly a linear guide to stretch the carrier film (4).

3. Apparatus according to claim 2, **characterized in that** the guide track (15) runs at an incline relative to the support surface (16) of the support (8), more particularly perpendicular, in order to put peeling stress on the material-fit connection between carrier film (4) and reinforcement edge (2).

4. Apparatus according to claim 2 or 3, **characterized in that** the guide (14) bears the clamping device (10) so that it can be moved from a starting position (17), in which it is planar with the support surface (16), into a clamping position (28), which is set back relative to the support surface (16).

5. Apparatus according to one of claims 1 to 4, **characterized in that** the clamping device (10) has suction openings (9) for drawing the support film (4) and/or the wafer frame (11) in by suction.

6. Apparatus according to one of claims 1 to 5, **characterized in that** a pivot bearing (19) is provided between holding device (7) and disaggregating tool (12).

7. Apparatus according to claim 6, **characterized in that** the axis of rotation (20) of the pivot bearing (19) runs inclined relative to the guide axis (21) of the tool guide (13), more particularly perpendicular.

8. Apparatus according to one of claims 1 to 7, **characterized in that** the disaggregating tool (12) has a wedge blade (22), more particularly is structured as a knife (23) or splitter.

9. Apparatus according to one of claims 1 to 8, **characterized in that** the severing device (6) has a radiation source (24) directed at the reinforcement edge (2), for softening the material-fit connection between carrier film (4) and reinforcement edge (2).

10. Apparatus according to claim 9, **characterized in that** a shutter (25) for restricting the emission (26) of the radiation source (24) to the reinforcement edge (2) follows the radiation source (24).

11. Apparatus according to one of claims 1 to 10, **characterized in that** the support (8) draws the semiconductor wafer (3) against the carrier film (4) with suction.

12. Apparatus according to one of claims 1 to 11, **characterized in that** the suction openings (9) of the support (8) are disposed to run around the inside (27) of the reinforcement edge (2).

## Revendications

1. Dispositif pour enlever un bord de renfort (2) annulaire d'une plaquette de semiconducteur (3) poncée qui est assemblée en solidarité de matière à un film de support élastique (4) et fixée par ce film de support (4) sur un cadre de plaquette (11) qui en fait le tour, avec un dispositif de maintien (7) comprenant un appui (8) muni d'ouvertures d'aspiration (9) destinées à retenir la plaquette de semiconducteur (3) sur la surface d'appui (16) de l'appui (8) et avec un dispositif de séparation (6) comprenant des moyens pour détacher d'une pièce le bord de renfort (2) du film de support (4), dans lequel le dispositif de maintien (7) comporte un dispositif de serrage (10) qui comprend l'appui (8) pour le serrage du cadre de plaquette (11) et/ou du film de support (4), **caractérisé en ce que** le dispositif de serrage (10) coopère avec l'appui (8) pour étirer le film de support (4) entre le dispositif de serrage (10) et le bord de renfort (2) et **en ce que** le dispositif de séparation (6) présente un guide d'outil (13) avec un outil diviseur (12), destiné à déplacer l'outil diviseur (12) entre le film de support (4) étiré et le bord de renfort (2) afin de détacher d'une pièce le bord de renfort (2) du film de support (4) étiré par la coopération du dispositif de serrage (10) et de l'appui (8).

2. Dispositif selon la revendication 1, **caractérisé en ce que** le dispositif de maintien (7) pour l'étirage du film de support (4) comprend un guide (14), en particulier linéaire, prévu entre le dispositif de serrage (10) et l'appui (8).

3. Dispositif selon la revendication 2, **caractérisé en ce que** la piste de guidage (15) est inclinée par rapport à la surface d'appui (16) de l'appui (8), en particulier perpendiculaire, afin d'exercer une force de pelage sur l'assemblage par solidarité de matière entre le film de support (4) et le bord de renfort (2).

4. Dispositif selon la revendication 2 ou 3, **caractérisé en ce que** le guide (14) supporte le dispositif de serrage (10) avec possibilité de déplacement d'une position de départ (17) en affleurement avec la surface d'appui (16) à une position de serrage (28) reculée par rapport à la surface d'appui (16).

5. Dispositif selon l'une des revendications 1 à 4, **caractérisé en ce que** le dispositif de serrage (10) présente des ouvertures d'aspiration (9) pour aspirer le film de support (4) et/ou le cadre de plaquette (11).

6. Dispositif selon l'une des revendications 1 à 5, **caractérisé en ce qu'**un palier pivotant (19) est prévu entre le dispositif de maintien (7) et l'outil diviseur (12).

7. Dispositif selon la revendication 6, **caractérisé en ce que** l'axe de rotation (20) du palier pivotant (19) est incliné par rapport à l'axe de guidage (21) du guide d'outil (13), en particulier perpendiculaire.

8. Dispositif selon l'une des revendications 1 à 7, **caractérisé en ce que** l'outil diviseur (12) présente une lame en coin (22) qui est réalisée en particulier comme un couteau (23) ou un fendoir.

9. Dispositif selon l'une des revendications 1 à 8, **caractérisé en ce que** le dispositif de séparation (6) présente une source de rayonnement (24) dirigée vers le bord de renfort (2) et destinée à ramollir l'assemblage par solidarité de matière entre le film de support (4) et le bord de renfort (2).

10. Dispositif selon la revendication 9, **caractérisé en ce que** la source de rayonnement (24) est suivie d'un volet (25) destiné à limiter l'irradiation (26) du bord de renfort (2) par la source de rayonnement (24).

11. Dispositif selon l'une des revendications 1 à 10, **caractérisé en ce que** l'appui (8) aspire la plaquette de semiconducteur (3) sur le film de support (4).

12. Dispositif selon l'une des revendications 1 à 11, **caractérisé en ce que** les ouvertures d'aspiration (9) de l'appui (8) sont disposées sur le tour de la face intérieure (27) du bord de renfort (2).
